Europäisches Patentamt

European Patent Office

Office européen des brevets

(19)

(11) Numéro de publication: **0 095 956**
**B1**

(12)

# FASCICULE DE BREVET EUROPEEN

(45) Date de publication du fascicule du brevet:
04.09.85

(51) Int. Cl.⁴: **G 01 R 31/08, H 02 H 3/38**

(21) Numéro de dépôt: **83400950.8**

(22) Date de dépôt: **11.05.83**

(54) Procédé de mesure de distance d'un défaut sur une ligne avec prise en compte des capacités réparties.

(30) Priorité: 26.05.82 FR 8209123

(43) Date de publication de la demande:
07.12.83 Bulletin 83/49

(45) Mention de la délivrance du brevet:
04.09.85 Bulletin 85/36

(84) Etats contractants désignés:
CH DE GB IT LI SE

(56) Documents cités:
DE - A - 2 932 929
DE - B - 2 523 005
FR - A - 1 376 746
FR - A - 1 436 596
FR - A - 1 566 425
FR - A - 2 057 232
US - A - 3 369 156
US - A - 3 593 124
US - A - 3 612 989
US - A - 3 931 502
US - A - 3 983 377

(73) Titulaire: **ENERTEC, 12 Place des Etats Unis,
F-92120 Montrouge (FR)**

(72) Inventeur: **Heller, Isabelle, 5, rue Charles Desvergnes,
F-92190 Meudon (FR)**
Inventeur: **Loewenstein, Paul, 1285 Montecito Avenue
Mountain View, California 94043 (US)**

(74) Mandataire: **Bentz, Jean-Paul, GIERS SCHLUMBERGER
Service BREVETS 12, place des Etats-Unis,
F-92124 Montrouge Cedex (FR)**

## Description

La présente invention concerne un procédé pour déterminer, en un point de mesure d'un réseau de transport d'énergie électrique, la distance entre ce point et un défaut affectant une ligne de ce réseau dont la résistance et l'inductance liniques sont connues, ou la résistance de ce défaut, consistant à produire des signaux de mesure instantanés de tension et de courant pour cette ligne, à produire, à partir de ces signaux de mesure, des signaux instantanés de traitement de tension et de courant reliés aux signaux de mesure respectifs par des fonctions de transfert, et à donner à ladite distance ou à ladite résistance la valeur qui, pour au moins un ensemble de signaux de traitement simultanés de tension et de courant, vérifie la loi d'Ohm appliquée à la ligne supposée résistive et inductive.

Des procédés de ce type sont connus et quelques exemples en sont donnés dans les brevets français FR 1376746, FR 1436596, FR 1566425, FR 2057232, et/ou dans les brevets américains US 3369156, US 3612989 et US 3593124.

Dans les formes les plus classiques de ces techniques antérieures, la loi d'Ohm est appliquée à la ligne en défaut supposée en antenne, et exclusivement résistive et inductive; il en résulte une équation incorporant les deux inconnues que sont d'une part la résistance du défaut et d'autre part la résistance séparant ce défaut du point de mesure.

La détermination de cette distance est obtenue soit en observant la loi d'Ohm, appliquée aux résistances et à l'inductance de ligne, au moment où le courant de la ligne en défaut s'annule, ce qui annule l'effet de la résistance de défaut, soit en observant la loi d'Ohm pour deux ensembles de signaux de mesure de tension et de courant correspondant à des instants de mesure différents.

Ces procédés connus, qui ont donné pleine satisfaction, souffrent cependant d'une limitation qui, dans le présent contexte d'accroissement continu de la longueur des lignes, se révèle de plus en plus gênante et qui consiste en ce que ces procédés ne rendent aucun compte des capacités réparties des lignes électriques.

Cependant, si les capacités réparties des lignes sont jusqu'à présent négligées, c'est qu'aucun moyen n'a pu être envisagé pour en rendre compte sans aboutir à une complexité sensiblement accrue des procédés à mettre en œuvre.

Dans ce contexte, le but de la présente invention est de proposer un procédé qui, sans accroître sensiblement la complexité des procédés connus de mesure de distance précédemment mentionnés, permette de prendre en compte les capacités réparties de la ligne dans les procédés de mesure directe de la distance d'un défaut.

Le procédé conforme à l'invention est essentiellement caractérisé en ce que le rapport de la fonction de transfert du signal de traitement de courant associé à l'inductance dans la loi d'Ohm, à la fonction de transfert du signal de traitement de tension est au moins sensiblement proportionnel à $(2/\tau)\text{tg}\omega\tau/2$, où $\tau$ correspond au temps de propagation réel d'une onde électrique sur le double de la distance séparant le point de mesure d'un point de référence de la ligne, et où $\omega$ est la variable de l'expression de la fonction de transfert, d'où il résulte au moins une diminution de l'erreur due, dans la détermination de la distance du défaut, à l'existence des capacités réparties de la ligne.

Dans un mode de réalisation préféré de l'invention, le rapport de la fonction de transfert du signal de traitement de courant associé à la résistance dans la loi d'Ohm, à la fonction de transfert du signal de traitement de tension est égal à ou voisin de l'unité.

Dans un mode de réalisation particulier de l'invention, chaque ensemble de signaux de traitement comprend une paire de signaux de traitement de tension et une première et une seconde paire de signaux de traitement de courant, les premiers signaux respectifs de chaque paire correspondant à un premier instant de mesure, les seconds signaux de chaque paire correspondant à un second instant de mesure, et l'intervalle temporel entre les premier et second instants correspondant audit temps de propagation; les signaux de ladite paire de signaux de traitement de tension sont combinés en une moyenne arithmétique pour au moins participer à constituer le terme de la loi d'Ohm qui est homogène à une tension.

Par ailleurs, les signaux de la première paire de signaux de traitement de courant sont combinés en une différence divisée par ledit temps de propagation pour au moins participer à constituer le terme de la loi d'Ohm, homogène à la dérivée temporelle d'un courant, qui est associé à l'inductance.

Dans un mode de réalisation simple de l'invention, les signaux de la seconde paire de signaux de courant sont combinés en une moyenne arithmétique pour au moins participer à constituer le terme de la loi d'Ohm, homogène à un courant, qui est associé à la résistance.

En outre, de préférence, l'intervalle temporel séparant les instants de mesure caractérisant les signaux des différentes paires correspond au moins sensiblement au temps de propagation d'une onde sur le double de la longueur d'une zone de la ligne.

Pour mieux cerner l'invention, il convient de rappeler qu'elle s'inscrit dans le cadre défini au début du présent préambule, et qu'elle ne se réduit donc pas à l'utilisation de signaux de traitement de courant et de tension retardés, par rapport à d'autres signaux de traitement en coïncidence avec les signaux de mesure, d'un intervalle temporel correspondant au temps de propagation réel d'une onde électrique sur le double d'une longueur prédéterminée de la ligne.

En effet, une telle utilisation, si on la considère isolément, est décrite dans le brevet britannique GB 1460347. Cependant, le procédé décrit dans ce brevet antérieur ne se place pas, quant à lui, dans le cadre de la mesure directe de la distance d'un défaut; plus précisément, ce procédé antérieur vise à reproduire les conditions électriques prévalant en un point de référence, dans le but d'élaborer plusieurs fonctions de pondération dont la comparaison devra permettre la localisation du défaut.

La présente invention, relative à la mesure directe de la distance du défaut, et consistant en des moyens d'application et de portée plus générales, se distingue donc nettement de ce brevet antérieur.

D'autres caractéristiques et avantages de l'invention ressortiront de la description qui en est faite ci-après, à titre indicatif et nullement limitatif, en référence au dessin annexé, sur lequel:

la fig. 1 est un schéma d'une portion de ligne en défaut;

la fig. 2 est un schéma d'un dispositif mettant en œuvre le procédé de l'invention dans le cas d'un défaut entre phases d'une ligne polyphasée, et

la fig. 3 est un schéma partiel d'un dispositif mettant en œuvre le procédé de l'invention dans le cas d'un défaut entre une phase et le neutre.

Comme indiqué dans le préambule, la présente invention concerne la mesure directe de la distance d'un défaut affectant une ligne électrique, par exemple monophasée ou polyphasée.

De façon traditionnelle, la ligne électrique 1 comporte à chacune de ses extrémités un relais 2 ayant notamment pour fonction de délivrer des signaux de mesure de tension et de courant apparaissant à chaque instant sur la ligne au point d'implantation M de ce relais, ou point de mesure.

Un relais installé sur une ligne polyphasée délivre à chaque instant autant de signaux de tension et de signaux de courant que la ligne comporte de phases.

Conformément aux techniques connues, le procédé de l'invention comprend l'élaboration, à partir des signaux de mesure, de signaux de traitement de tension et de courant qui, appliqués à la loi d'Ohm à laquelle la ligne en défaut, dont on connaît la résistance et l'inductance linéiques R et L, est supposée obéir, conduisent à la détermination de la distance du défaut. De façon connue, l'invention fait, formellement au moins, application de la loi d'Ohm restreinte aux résistances et à l'inductance.

Si l'on veut tenir compte de la résistance du défaut $R_d$, l'hypothèse est aussi faite que le courant instantané dans le défaut, $i(t)$, est identique au courant apparaissant au point de mesure; cette dernière hypothèse concerne le courant homopolaire dans le cas d'un défaut phase-terre d'une ligne polyphasée.

Ainsi, on peut considérer que la présente invention s'appuie, comme les procédés connus de mesure directe de distance de défaut, sur la formulation très générale de la loi d'Ohm:

$$v = x \cdot Ri + x \cdot L \frac{di}{dt} + R_d i \qquad (1)$$

où v et i sont les signaux de mesure de tension et de courant élaborés par le relais 2, x la distance du défaut; et $\frac{di}{dt}$ la dérivée temporelle du signal de courant. Le signal de traitement de courant $\frac{di}{dt}$ est obtenu à partir du signal de mesure de courant $i(t)$.

Or si l'on pose $L_E = x \cdot L$, et
$$R_E = x \cdot R + R_d,$$
on remarque que la loi d'Ohm est également formulée par l'égalité:

$$v = R_E \cdot i + L_E \cdot \frac{di}{dt} \qquad (2)$$

Les valeurs de $R_E$ et $L_E$, donc de x et $R_d$, peuvent être dérivées de l'observation de la loi d'Ohm à deux instants différents t et t', c'est-à-dire de la résolution du système de Cramer (3):

$$\begin{cases} v(t) = R_E \cdot i(t) + L_E \cdot \frac{di}{dt}(t) \\ v(t') = R_E \cdot i(t') + L_E \cdot \frac{di}{dt}(t') \end{cases}$$

Il est à noter que les signaux de tension $v(t)$ et de courant $i(t)$ apparaissant dans ce système peuvent être considérés à la fois comme des signaux de mesure puisqu'ils sont directement représentatifs de la tension et du courant au point de mesure, et comme des signaux de traitement puisqu'ils sont appliqués à la loi d'Ohm en vue de la mesure de la distance du défaut; en tant que signaux de traitement, $v(t)$ et $i(t)$ dérivent des signaux de mesure par des fonctions de transfert évidemment égales à l'unité.

On remarque aussi que si la mesure de la résistance de défaut $R_d$ n'est pas nécessaire, la mesure de la distance x peut dériver, de façon plus simple encore, de l'observation de la loi d'Ohm à un instant $t_o$ tel que $i(t_o) = 0$; en effet, on a alors l'égalité (4):

$$\frac{1}{x} = L \cdot \frac{di}{dt}(to)/v(to)$$

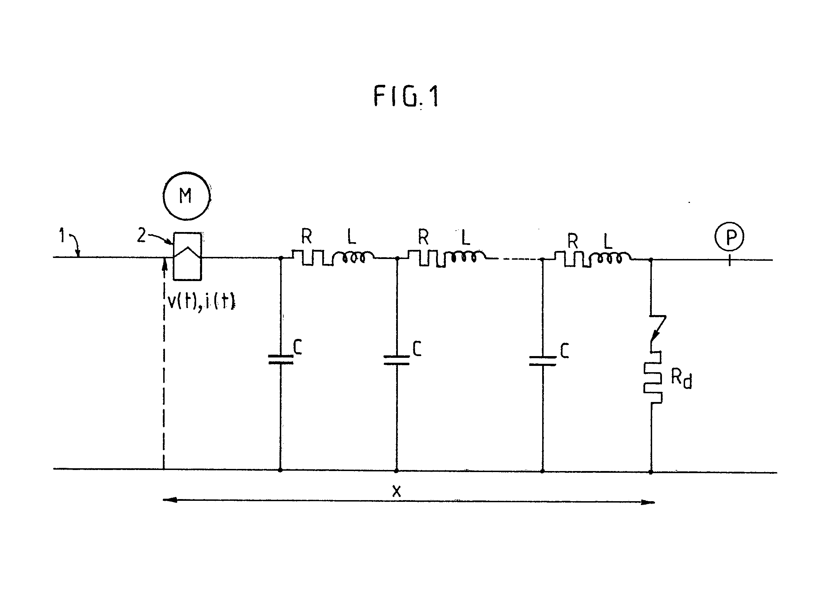

Cependant, rien dans ces procédés connus ne fait référence, même de façon implicite, aux capacités réparties C de la ligne (fig. 1), et il s'avère que ces capacités négligées introduisent dans la mesure de x une erreur qui peut ne pas être négligeable.

Dans ce contexte, le procédé de l'invention, toujours basé sur les formulations (1) ou (2) de la loi d'Ohm, et visant à prendre en compte les capacités réparties de ligne, consiste essentiellement en ce que le rapport de la fonction de transfert du signal de traitement de courant associé à l'inductance dans la loi d'Ohm, à la fonction de transfert du signal de traitement de tension est au moins sensiblement proportionnel à $(2/\tau)\mathrm{tg}\,\omega\tau/2$, où $\tau$ correspond au temps de propagation réel d'une onde électrique sur le double de la distance séparant le point de mesure d'un point de référence P de la ligne, et où $\omega$ est la variable de l'expression de la fonction de transfert; en outre, de préférence, le rapport de la fonction de transfert du signal de traitement de courant associé à la résistance dans la loi d'Ohm, à la fonction de transfert du signal de traitement de tension est égal à ou voisin de l'unité.

De façon explicite, l'invention peut ainsi être considérée comme reposant sur l'égalité (5):

$$T_1 \cdot v = R_E \cdot T_2 \cdot i + L_E \cdot R_3 \cdot i$$

où $T_1$, $T_2$, $T_3$ sont les fonctions de transfert reliant les signaux de traitement de tension et de courant

$T_1 \cdot v$, $T_2 \cdot i$, $T_3 \cdot i$ aux signaux de mesure de tension et de courant v et i, et telles que

$$R_3/T_1 = k \cdot (2/\tau) \, tg\omega\tau \text{ et } T_2 = T_1.$$

Par exemple, $T_2 = T_1 = (1 + \exp\text{-}j\omega\tau)/2$, et $T_3 = (1\text{-}\exp\text{-}j\omega\tau)/\tau$, auquel cas le paramètre k devient le nombre imaginaire pur j.

L'introduction, dans les formulations (1) ou (2) de la loi d'Ohm, de l'intervalle de temps $\tau$, qui correspond à un temps de propagation réel, c'est-à-dire à une grandeur qui dépend des capacités réparties de la ligne, permet de façon simple et efficace de prendre en compte ces capacités.

Il en résulte une réduction sensible de l'erreur sur la mesure de la distance ou de la résistance d'un défaut, qui est minimale pour un défaut apparaissant au point de référence P.

Lorsque la ligne est découpée en plusieurs zones, il est ainsi avantageux que le point de référence P coïncide avec une limite de zone.

Les signaux de traitement de tension et de courant $T_1 \cdot v$, $T_2 \cdot i$, $T_3 \cdot i$ peuvent par exemple être obtenus à partir des signaux de mesure v et i au moyen d'un filtrage connu en soi, qu'il n'est donc pas utile de décrire ici, et peuvent être utilisés à la place des signaux $v(t)$, $i(t)$, et $\dfrac{di}{dt}$ dans les expressions (3) ou (4) pour aboutir, comme dans l'art antérieur, mais avec une bien meilleure précision, à la détermination de la distance du défaut.

Dans un mode de réalisation particulier, le procédé de l'invention consiste essentiellement à utiliser des paires de signaux de traitement de tension et des paires de signaux de traitement de courant, les premier et second signaux de chaque paire correspondant à des instants de mesure différents séparés par un intervalle de temps égal audit temps de propagation réel d'une onde électrique sur le double de la distance séparant le point de mesure d'un point de référence P de la ligne.

Dans cette forme particulière, l'invention peut ainsi être considérée comme reposant sur l'égalité (6) ci-dessous:

$$[v(t) + v(t\text{-}\tau)]/2 = x \cdot Ri(t) + x \cdot L[i(t)\text{-}i(t\text{-}\tau)]/\tau + R_d i(t)$$

dans laquelle apparaissent les paires de signaux $v(t)$, $v(t\text{-}\tau)$ et $i(t)$, $i(t\text{-}\tau)$.

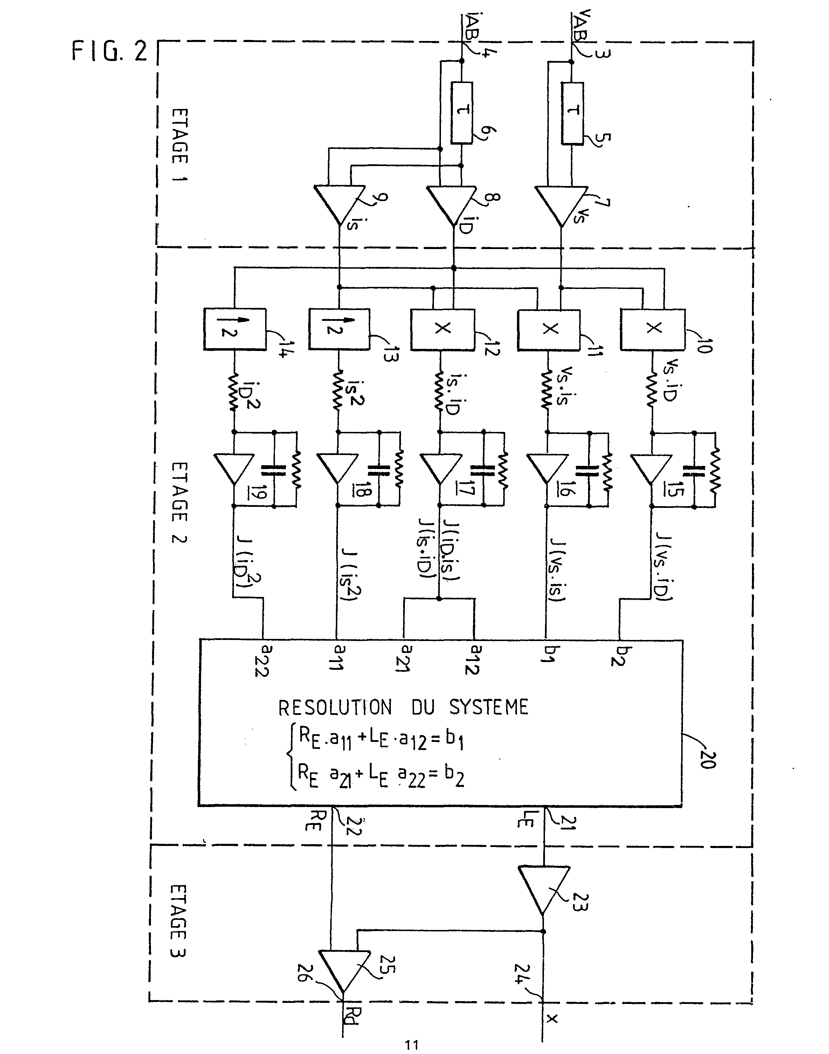

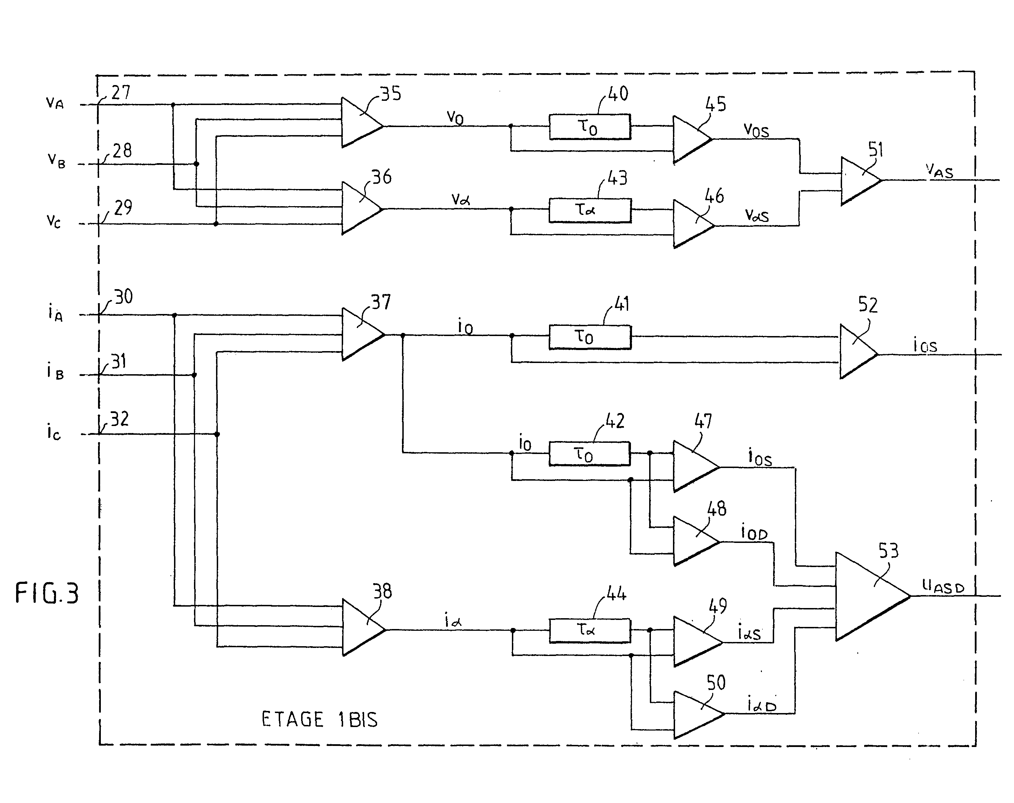

Sous une forme de réalisation simplifiée, illustrée par les fig. 2 et 3, le procédé de l'invention peut encore être considéré comme reposant sur l'égalité:

$$[v(t) + v(t\text{-}\tau)]/2 = x \cdot R[i(t) + i(t\text{-}\tau)]/2 + X \cdot L[i(t)\text{-}i(t\text{-}\tau)]/\tau + R_d[i(t) + i(t\text{-}\tau)]/2 \quad (7)$$

Il est à noter que l'égalité (7) correspond à l'égalité (5) écrite pour des fonctions de transfert $T_1 = T_2 = (1 + \exp\text{-}j\omega\tau)/2$ et $T_3 = (1\text{-}\exp\text{-}j\omega\tau)/\tau$.

La fig. 2 est relative à un dispositif et à un procédé de mesure de distance d'un défaut entre les phases A et B d'une ligne triphasée.

Le dispositif représenté reçoit sur ses entrées 3 et 4 des signaux de mesure de tension et de courant entre phases $v_{AB}$ et $i_{AB}$.

Les circuits à retard 5 et 6 retardent respectivement les signaux $v_{AB}$ et $i_{AB}$ d'un intervalle temporel $\tau$ égal au double du temps de propagation d'une onde électrique, en mode interphase, entre le point de mesure M et le point de référence P.

Les amplificateurs sommateurs 7, 8 et 9, reliés aux entrées 3, 4 et aux circuits à retard 5, 6 respectifs, élaborent respectivement les signaux $v_S$, $i_D$ et $i_S$ tels que:

$$v_S = (1/2) \cdot [v_{AB}(t) + v_{AB}(t\text{-}\tau)]$$
$$i_D = (1/\tau) \cdot [i_{AB}(t)\text{-}i_{AB}(t\text{-}\tau)]$$
$$i_S = (1/2) \cdot [i_{AB}(t\text{-}\tau)]$$

Des multiplicateurs 10, 11, 12 respectivement reliés aux sorties des amplificateurs 7 et 8, 7 et 9, et 8 et 9, élaborent les produits de signaux respectifs $v_S \cdot i_D$, $v_S \cdot i_S$ et $i_S \cdot i_D$, tandis que des générateurs de la fonction élévation au carré 13 et 14, respectivement reliés aux amplificateurs 9 et 8, élaborent les signaux respectifs $i_S^2$ et $i_D^2$.

Les signaux issus des multiplicateurs et des générateurs de fonction sont intégrés par rapport au temps dans les intégrateurs respectifs 15 à 19 pour former les signaux intégrés: $J(v_S \cdot i_D)$, $J(v_S \cdot i_S)$, $J(i_D \cdot i_S) = J(i_S \cdot i_D)$, $J(i_S^2)$, et $J(i_D^2)$.

Ces signaux intégrés sont fournis à un circuit logique 20, par exemple un ordinateur, dont les sorties 21 et 22 délivrent respectivement des signaux $L_E$ et $R_E$ tels que:

$$J(v_S \cdot i_S) = R_E \cdot J(i_S^2) + L_E \cdot J(i_D \cdot i_S), \text{ et}$$
$$J(v_S \cdot i_D) = R_E \cdot J(i_S \cdot i_D) + L_E \cdot J(i_D^2).$$

Le signal $L_E$ est fourni à un amplificateur 23 qui délivre, à la sortie 24 du dispositif, le signal $L_E/L = x$ représentant la distance du défaut.

En outre, l'amplificateur 25, recevant les signaux x et $R_E$, fournit à la sortie 26 du dispositif le signal $R_E \text{-} x R = R_d$ représentant la résistance du défaut.

Il est à noter que le dispositif de la fig. 2 non seulement utilise les paires de signaux de traitement $v_{AB}(t)$, $v_{AB}(t\text{-}\tau)$ et $i_{AB}(t)$, $i_{AB}(t\text{-}\tau)$ mais en outre met à profit, dans le mode de réalisation particulier de l'invention qu'il constitue, l'indépendance, au sens de l'algèbre linéaire, des signaux $i_S$ et $i_D$, c'est-à-dire, en définitive, des signaux $i_{AB}(t)$ et $i_{AB}(t\text{-}\tau)$.

La fig. 3 est relative au premier étage d'un dispositif de mesure de distance d'un défaut entre la phase A d'une ligne triphasée et la terre.

Cet étage, désigné par 1 BIS pour la raison qu'il peut, conformément à ce qui est décrit ci-après, se substituer à l'étage 1 du dispositif de la fig. 2, reçoit, sur ses entrées 27, 28 et 29, les signaux de mesure de tension $v_A$, $v_B$, $v_C$ des trois phases de la ligne, et sur ses entrées 30, 31 et 32, les signaux de mesure de courant $i_A$, $i_B$, $i_C$ des trois phases.

L'amplificateur sommateur 35, relié aux entrées 27, 28 et 29, élabore le signal de tension homopolaire:

$$v_o = (v_A + v_B + v_C)/3$$

L'amplificateur sommateur 36, relié aux entrées 27, 28 et 29, élabore le signal $v_\alpha$, représentant la composante $\alpha$ de Clarke ou bifilaire, de la tension, donné par:

$$v_\alpha = (2v_A \text{-} v_B \text{-} v_C)/3$$

L'amplificateur sommateur 37, relié aux entrées 30, 31 et 32, élabore le signal de courant homopolaire :

$$i_o = (i_A + i_B + i_C)/3$$

Enfin l'amplificateur sommateur 38, relié aux entrées 30, 31 et 32, élabore le signal $i_\alpha$, représentant la composante $\alpha$ de Clarke, ou bifilaire, du courant, donné par :

$$i_\alpha = (2i_A - i_B - i_C)/3$$

Trois circuits à retard 40 d'une part, et 41, 42 d'autre part, sont respectivement reliés aux sorties des amplificateurs 35 et 37, pour introduire un retard $\tau_o$ égal au double du temps de propagation d'une onde électrique, en mode homopolaire, entre le point de mesure et le point de référence.

Deux autres circuits à retard 43 et 44 sont respectivement reliés aux sorties des amplificateurs 36 et 38, pour introduire un retard $\tau_\alpha$ égal au double du temps de propagation d'une onde électrique, en mode bifilaire, entre le point de mesure et le point de référence.

Un amplificateur sommateur 45, relié à la sortie de l'amplificateur 35 et du circuit à retard 40, élabore un signal $v_{os}$ donné par :

$$v_{os} = [v_o(t) + v_o(t-\tau_o)]/2$$

Un amplificateur sommateur 46, relié à la sortie de l'amplificateur 36 et du circuit à retard 43, élabore un signal $v_{\alpha s}$ donné par :

$$v_{\alpha s} = [v_\alpha(t) + v_\alpha(t-\tau_\alpha)]/2$$

Un amplificateur sommateur 47, relié à la sortie de l'amplificateur 37 et du circuit à retard 42, élabore un signal $i_{os}$ donné par :

$$i_{os} = [i_o(t) + i_o(t-\tau_o)]/2$$

Un amplificateur sommateur 48, relié à la sortie de l'amplificateur 37 et du circuit à retard 42, élabore un signal $i_{oD}$ donné par :

$$i_{oD} = [i_o(t) - i_o(t-\tau_o)]/\tau_o$$

Un amplificateur sommateur 49, relié à la sortie de l'amplificateur 38 et du circuit à retard 44, élabore un signal $i_{\alpha s}$ donné par :

$$i_{\alpha s} = [i_\alpha(t) + i_\alpha(t-\tau_\alpha)]/2$$

Un amplificateur sommateur 50, relié à la sortie de l'amplificateur 38 et du circuit à retard 44, élabore un signal $i_{\alpha D}$ donné par :

$$i_{\alpha D} = [i_\alpha(t) - i_\alpha(t-\tau_\alpha)]/\tau_\alpha$$

Un amplificateur sommateur 51, relié aux sorties des amplificateurs 45 et 46, élabore un signal $v_{AS}$ donné par :

$$v_{AS} = (v_{os} + v_{\alpha s})/2$$

Un amplificateur sommateur 52, relié à la sortie de l'amplificateur 37 et du circuit à retard 41, élabore un signal $i_{os}$ donné par :

$$i_{os} = [i_o(t) + i_o(t-\tau_o)]/2$$

Enfin, un amplificateur sommateur 53, relié aux sorties des amplificateurs 47 à 50, élabore un signal $u_{ASD}$ donné par :

$$u_{ASD} = R_o \cdot i_{os} + R_\alpha \cdot i_{\alpha s} + L_o \cdot i_{oD} + L_\alpha \cdot i_{\alpha D}$$

où $R_o$ et $L_o$ sont les résistance et inductance linéiques homopolaires de la ligne, et où $R_\alpha$ et $L_\alpha$ sont les résistance et inductance linéiques bifilaires de la ligne.

Comme la loi d'Ohm appliquée à la ligne en défaut conduit à l'expression :

$$v_{AS} = x \cdot u_{ASD} + 3 R_d \cdot i_{os},$$

il suffit de connecter les amplificateurs 51, 52 et 53 du dispositif de la fig. 2 à l'étage 2 du dispositif de la fig. 1, à la place des amplificateurs 7, 8 et 9, respectivement, pour obtenir directement, sur les sorties 21 et 22 du circuit logique 20, les signaux x et 3 $R_d$ représentant respectivement la distance du défaut et le triple de la résistance de défaut.

Comme le dispositif décrit en référence à un défaut entre phases, le dispositif précédent met en œuvre des paires de signaux de traitement de tension, tels que $v_o(t)$, $v_o(t-\tau_o)$, et $v_\alpha(t)$, $v_\alpha(t-\tau_\alpha)$ ainsi que des paires de signaux de traitement de courant, tels que $i_o(t)$, $i_o(t-\tau_o)$, et $i_\alpha(t)$ et $i_\alpha(t-\tau_\alpha)$ ; en outre, ce dernier dispositif met également à profit, dans l'étage 2, l'indépendance linéaire des signaux des différentes paires.

## Revendications

1. Procédé pour déterminer, en un point de mesure (M) d'un réseau de transport d'énergie électrique, la distance (x) entre ce point et un défaut affectant une ligne de ce réseau dont la résistance (R) et l'inductance (L) linéiques sont connues, ou la résistance (Rd) de ce défaut, consistant à produire des signaux de mesure instantanés de tension et de courant pour cette ligne, à produire, à partir de ces signaux de mesure, des signaux instantanés de traitement de tension et de courant reliés aux signaux de mesure respectifs par des fonctions de transfert, et à donner à ladite distance ou à ladite résistance de défaut la valeur qui, pour au moins un ensemble de signaux de traitement simultanés de tension et de courant, vérifie la loi d'Ohm appliquée à la ligne supposée résistive et inductive, caractérisé en ce que le rapport de la fonction de transfert du signal de traitement de courant associé à l'inductance dans la loi d'Ohm, à la fonction de transfert du signal de traitement de tension est au moins sensiblement proportionnel à $(2/\tau)\text{tg}\omega\tau/2$, où $\tau$ correspond au temps de propagation réel d'une onde électrique sur le double de la distance séparant le point de mesure (M) d'un point de référence (R) de la ligne, et où $\omega$ est la variable de l'expression de la fonction de transfert, d'où il résulte au moins une diminution de l'erreur due, dans la détermination de la distance du défaut, à l'existence des capacités réparties de la ligne.

2. Procédé suivant la revendication 1, caractérisé en ce que le rapport de la fonction de transfert du signal de traitement de courant associé à la résistance dans la loi d'Ohm, à la fonction de transfert du signal de traitement de tension est égal à ou voisin de l'unité.

3. Procédé suivant la revendication 2, caractérisé en ce que chaque ensemble de signaux de traitement comprend une paire de signaux de traitement de tension et une première et une seconde paire de signaux de traitement de courant, les premiers signaux respectifs de chaque paire correspondant à un premier instant de mesure, les seconds signaux de chaque paire correspondant à un second instant de mesure, et l'intervalle temporel entre les premier et second instants correspondant audit temps de propagation.

4. Procédé suivant la revendication 3, caractérisé en ce que lesdits signaux de ladite paire de signaux de traitement de tension sont combinés en une moyenne arithmétique pour au moins participer à constituer le terme de la loi d'Ohm qui est homogène à une tension.

5. Procédé suivant la revendication 3 ou 4, caractérisé en ce que lesdits signaux de ladite première paire de signaux de traitement de courant sont combinés en une différence divisée par ledit temps de propagation pour au moins participer à constituer le terme de la loi d'Ohm, homogène à la dérivée temporelle d'un courant, qui est associé à l'inductance.

6. Procédé suivant l'une quelconque des revendications 3 à 5, caractérisé en ce que lesdits signaux de ladite seconde paire de signaux de courant sont combinés en une moyenne arithmétique pour au moins participer à constituer le terme de la loi d'Ohm, homogène à un courant, qui est associé à la résistance.

7. Procédé suivant l'une quelconque des revendications précédentes, appliqué à une ligne découpée en zones, caractérisé en ce que ladite distance séparant le point de mesure dudit point de référence de la ligne est voisine de, ou égale à, la longueur d'une zone.

## Patentansprüche

1. Verfahren zur Bestimmung der Entfernung (x) zwischen einem Messpunkt (M) eines elektrischen Stromübertragungsnetzes und einem Fehler, der eine Leitung dieses Netzes beeinträchtigt, deren Leitungswiderstand (R) und -induktivität (L) bekannt sind, oder des Widerstandes (Rd) dieses Fehlers, welches darin besteht, dass Messsignale der Augenblickswerte von Spannung und Strom für diese Leitung erzeugt werden, aus diesen Messsignalen Spannungs- und Strom-Augenblicks-Verarbeitungssignale erzeugt werden, die mit den jeweiligen Messsignalen über Übertragungsfunktionen verknüpft sind, und dass der genannten Entfernung oder dem genannten Widerstand des Fehlers derjenige Wert gegeben wird, der für wenigstens eine Menge von gleichzeitigen Spannungs- und Strom-Verarbeitungssignalen das Ohmsche Gesetz erfüllt, angewendet auf die als resistiv und induktiv angenommene Leitung, dadurch gekennzeichnet, dass das Verhältnis der Übertragungsfunktion des Strom-Verarbeitungssignals, welches der Induktivität im Ohmschen Gesetz zugeordnet ist, zu der Übertragungsfunktion des Spannungs-Verarbeitungssignals wenigstens im wesentlichen proportional zu $(2/\tau)\mathrm{tg}\,\omega\tau/2$ ist, worin $\tau$ der reellen Ausbreitungszeit einer elektrischen Welle über die doppelte Entfernung zwischen dem Messpunkt (M) und einem Referenzpunkt (R) der Leitung entspricht und worin $\omega$ die Variable des Ausdrucks der Übertragungsfunktion ist, woraus zumindest eine Verkleinerung des Fehlers resultiert, der bei der Bestimmung der Entfernung des Fehlers auf dem Vorhandensein von über die Leitung verteilten Kapazitäten beruht.

2. Verfahren nach Anspruch 1, dadurch gekennzeichnet, dass das Verhältnis der Übertragungsfunktion des Strom-Verarbeitungssignals, welches dem Widerstand im Ohmschen Gesetz zugeordnet ist, zur Übertragungsfunktion des Spannungs-Verarbeitungssignals gleich oder ungefähr gleich 1 ist.

3. Verfahren nach Anspruch 2, dadurch gekennzeichnet, dass jede Menge von Verarbeitungssignalen ein Spannungs-Verarbeitungssignalpaar und ein erstes sowie ein zweites Strom-Verarbeitungssignalpaar umfasst, wobei jeweils die ersten Signale jedes Paares einem ersten Messzeitpunkt und die zweiten Signale jedes Paares einem zweiten Messzeitpunkt entsprechen und das Zeitintervall zwischen dem ersten und dem zweiten Zeitpunkt der genannten Ausbreitungszeit entspricht.

4. Verfahren nach Anspruch 3, dadurch gekennzeichnet, dass die genannten Signale des genannten Spannungs-Verarbeitungssignalpaares zu einem arithmetischen Mittelwert kombiniert werden, um wenigstens an der Bildung desjenigen Terms des Ohmschen Gesetzes teilzunehmen, der zu einer Spannung homogen ist.

5. Verfahren nach Anspruch 3 oder 4, dadurch gekennzeichnet, dass die genannten Signale des ersten Strom-Verarbeitungssignalpaares zu einer Differenz kombiniert werden, welche durch die genannte Ausbreitungszeit dividiert wird, um an der Bildung desjenigen Terms des Ohmschen Gesetzes wenigstens Anteil zu haben, welcher homogen zu der zeitlichen Ableitung eines Stromes ist, welcher der Induktivität zugeordnet ist.

6. Verfahren nach einem der Ansprüche 3 bis 5, dadurch gekennzeichnet, dass die genannten Signale des zweiten Strom-Signalpaares zu einem arithmetischen Mittelwert kombiniert werden, um an der Bildung desjenigen Terms des Ohmschen Gesetzes wenigstens Anteil zu haben, welcher homogen zu einem Strom ist, der dem Widerstand zugeordnet ist.

7. Verfahren nach einem der vorstehenden Ansprüche, angewendet auf eine in Zonen unterteilte Leitung, dadurch gekennzeichnet, dass die genannte Entfernung zwischen dem Messpunkt und dem Referenzpunkt der Leitung gleich oder ungefähr gleich der Länge einer Zone ist.

## Claims

1. Method for determining, at a measuring point (M) on an electricity transmission network, the distance (x) between this point and a fault affecting a line in the network, the resistance (R) and inductance (L) per unit length of which are known, or for determining the resistance (Rd) of this fault, comprising deriving instantaneous measurement signals of the voltage and current on the line, deriving, from these measurement signals, instantaneous processing signals of voltage and current related to the respective measurement signals by transfer functions, and giving the said distance or the said resistance of the fault the value which, for at least one group of simultaneous processing signals of voltage and current conforms to Ohm's Law applied to the line considered as resistive and inductive, characterized in that the ratio of the transfer function for the current processing signal associated with the inductance in Ohm's Law, to the transfer function for the voltage processing signal is at least substantially proportional to $(2/\tau)\mathrm{tg}\omega\tau/2$, where $\tau$ corresponds to the real propagation time of an electric wave over double the distance separating the measuring point (M) from a reference point (P) on the line, and where $\omega$ is the variable in the transfer function expression, whereby there results at least a reduction in the error, in the determination of the distance of the fault, due to the existence of distributed capacitances on the line.

2. Method according to claim 1, characterized in that the ratio of the transfer function for the current processing signal associated with the resistance in Ohm's Law, to the transfer function for the voltage processing signal is equal or close to unity.

3. Method according to claim 2, characterized in that each group of processing signals comprises a pair of voltage processing signals and a first and a second pair of current processing signals, the first respective signals of each pair corresponding to a first measuring instant, the second signals of each pair corresponding to a second measuring instant, and the time interval between the first and second instants corresponding to the said propagation time.

4. Method according to claim 3, characterized in that the said signals of the said pair of voltage processing signals are combined as an arithmetic mean to at least contribute to forming the term of Ohm's Law which is equivalent to a voltage.

5. Method according to claim 3 or 4, characterized in that the said signals of the said first pair of current processing signals are combined as a difference divided by the said propagation time to at least contribute to forming the term of Ohm's Law, equivalent to the time derivative of a current, which is associated with the inductance.

6. Method according to any of claims 3 to 5, characterized in that the said signals of the said second pair of current signals are combined as an arithmetic mean to at least contribute to forming the term of Ohm's Law, equivalent to a current, which is associated with the resistance.

7. Method according to any of the preceding claims, applied to a line divided into zones, characterized in that the said distance separating the measuring point from the said reference point on the line is close, or equal, to the length of a zone.

# FIG.1

0 095 956

FIG. 2

ETAGE 1

ETAGE 2

RESOLUTION DU SYSTEME

$$\begin{cases} R_E \cdot a_{11} + L_E \cdot a_{12} = b_1 \\ R_E \, a_{21} + L_E \, a_{22} = b_2 \end{cases}$$

ETAGE 3

11

FIG.3

ETAGE 1BIS